# EUROPEAN PATENT APPLICATION

(11) **EP 0 961 315 A1**
(43) Date of publication of application: **01.12.1999**
(21) Application number: 99303640.9
(22) Date of filing: 10.05.1999
(51) Int. Cl.: H01L 21/3105

(54) **Chemical mechanical polishing process for integrated circuits using a patterned stop layer**

(30) Priority: 19.05.1998 US 80987
(71) Applicant: LUCENT TECHNOLOGIES INC., Murray Hill, New Jersey 07974-0636 (US)
(72) Inventor: Maury, Alvaro, Orlando, Florida 32819 (US); Steiner, Kurt George, Orlando, Florida 32836 (US)
(74) Representative: Johnston, Kenneth Graham

(57) **Abstract**

An integrated system and process of polishing a substrate. The process includes forming a stop layer (e.g., 220) on a substrate and patterning the stop layer to form a patterned layer. A first layer (e.g., 230) is formed on the patterned layer and polished. A second layer (e.g., 240) is formed on the polished first layer and the patterned layer.

## Description

### Field of the Invention

The present invention relates generally to integrated circuit manufacturing and, more particularly, to chemical mechanical polishing an integrated circuit.

### Background of the Invention

Chemical-mechanical polishing (CMP) is used extensively in the manufacture of semiconductor devices. An exemplary CMP system is shown in U.S Patent No. 5,081,421 entitled IN SITU MONITORING TECHNIQUE AND APPARATUS FOR CHEMICAL/MECHANICAL PLANARIZATION ENDPOINT DETECTION, issued to Miller et al. and dated January 14, 1992 and assigned to the same assignee of this invention. This patent is incorporated herein by reference for its teachings on chemical mechanical polishing.

One application of chemical-Mechanical polishing (CMP) is the planarization of inter-level dielectric layers in multilevel metallization applications. Typically, an oxide layer is formed on a patterned metal layer. The density of the metal pattern induces variations in the oxide layer thickness. CMP is used to planarize the oxide layer.

With recent efforts in developing CMP-only shallow trench isolation, several slurry manufacturers have started offering slurries with high oxide-to-nitride selectivity. For example, Rodel, Inc. of 451 Bellevue Rd., Newark, DE 19713 has developed a ceria based slurry , Corundum (a trademark of Rodel), with an oxide/nitride selectivity that can be as high as 150. The research consortium, SEMATECH of 2706 Montopolis Dr., Austin, TX 78741, is investigating a slurry-less pad with micro-replicated ceria abrasive "pyramids", developed by 3M Corporation of 3M Center, Saint Paul, MN 55144. By tailoring the pH of the liquid added to the pad for polishing, the oxide/nitride selectivity can be enhanced.

Although there has been much work in this area, the CMP process for oxide suffers from two problems. The first is that the metal pattern density on the substrate induces variations in the oxide thickness after CMP. For example, consider the device shown in Fig. 7. A patterned layer 700 is formed on a substrate 710 An intermediate layer 715 is formed on the patterned layer 700. The intermediate layer 715 is, for example, an oxide. The thickness Z of the intermediate layer 715 varies because the intermediate 715 replicates the variations in the patterned layer 700.

The second problem is that a simple, reliable, end-point detection system has not yet been developed. These problems make the CMP for oxide relatively costly, and with low throughput, due to the use of a high number of rate/uniformity monitor wafers in the polisher with the wafers to be polished, and careful setup for every new wafer level/code to be polished. In ASIC applications, variations in oxide thickness across a die are particularly troublesome because yield loss can occur if critical timing paths are affected by capacitance induced delays due to the variations. Thus, it would be an aspect of the invention to provide an integrated circuit and method for manufacturing an integrated circuit to overcoming these deficiencies.

### Summary of the Invention

To achieve this and other aspects of the invention, and in view of its purposes, the present invention provides an integrated circuit and process of polishing a substrate. The process is directed to polishing a wafer on which a patterned stop layer is incorporated to substantially stop the polishing process when the stop layer is exposed. This process diminishes the need for an end point detection system to stop the polishing process. The stop layer provides the added advantage that it may be used as a hard mask during etching.

The integrated circuit is directed to a patterned stop layer formed on a metal layer and a further layer formed on the patterned stop layer and the metal layer. The stop layer is more resistant to polishing than the further layer and, as a result, the integrated circuit may be effectively manufactured using CMP.

It is to be understood that both the foregoing general description and the following detailed description are exemplary, but are not restrictive, of the invention.

### Brief Description of the Drawing

The invention is best understood from the following detailed description when read in connection with the accompanying drawing. It is emphasized that, according to common practice in the semiconductor industry, the various features of the drawing are not to scale. On the contrary, the dimensions of the various features are arbitrarily expanded or reduced for clarity. Included in the drawing are the following figures:
Fig. 1 is a flow chart diagram illustrating an exemplary embodiment of the present invention;

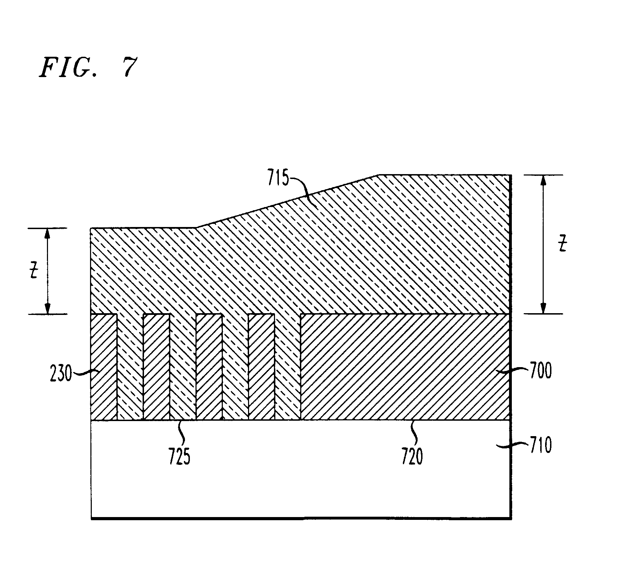

Figs. 2-6 are schematic diagrams showing an integrated circuit during successive stages of manufacture; and
Fig. 7 is a schematic diagram of a semiconductor device according to the prior art.

### Detailed Description of the Invention

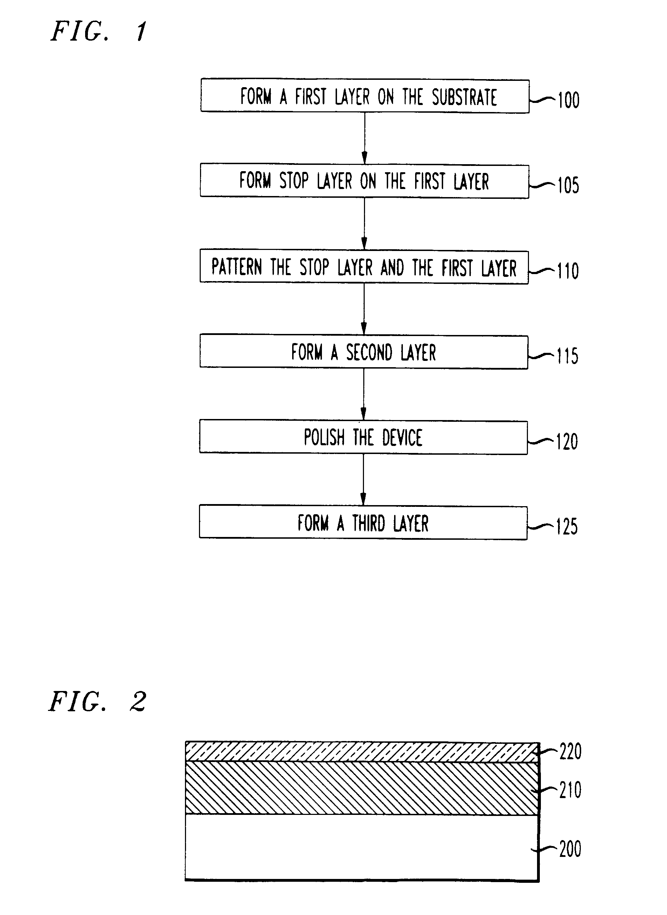

Referring now to the drawing, wherein like reference numerals refer to like elements throughout, Fig. 1 is a flow-chart diagram illustrating the present invention. Briefly, the present invention is directed to a process for manufacturing an integrated circuit. A stop layer is formed on a substrate. The stop layer is patterned to form a patterned layer. A first layer is formed on the patterned layer and the first layer is polished. The stop layer serves as a stop layer for the CMP process. This process diminishes the need for an end point detection system to stop the polishing process. The stop layer also provides the added advantage that it may be used as a hard mask during etching. This process is repeated until the upper surface of the stop layer and the upper surface of the second layer form a surface that is substantially uniform and/or substantially flat. Alternatively, this process may be repeated until the stop layer is reached. The high selectivity of the slurry allows for over-polish without attacking the intermediate layer. The stop layer serves as a stop layer for the CMP process. As a result, the need for accurate end point capability is not necessary.

This process is described in greater detail below with reference to Fig. 1. At step 100, an intermediate layer 210, shown in Fig. 2, is formed on a substrate 200. The intermediate layer 210 is, for example, a metal layer such as aluminum for forming interconnection lines in an integrated circuit. Alternatively, the metal layer may include titanium, tungsten, or other metals used in semiconductor devices as is known in the art. The substrate 200 may be formed from silicon, germanium, gallium arsenide or other materials known to those skilled in the art.

At step 105, a stop layer 220, shown in Fig. 2, is formed on the intermediate layer 210. The stop layer 220 is, for example, a dielectric anti-reflective coating. One material suitable for use in the stop layer 220 is inorganic silicon oxynitride (SiON). Alternatively, the stop layer 220 may be silicon nitride (Si₃N₄). The material for the stop layer 220 is selected so that it is resistant to the chemical-mechanical polishing and/or etching performed in subsequent steps to partially remove oxide formed on the substrate. In addition, the stop layer 220 serves as a hard mask for etching the metal layer 210.

At step 110, the stop layer 220 and the metal layer 210 are patterned. The stop layer 220 and the metal layer 210 may be patterned at substantially the same time or separately. These layers may be patterned by applying a photoresist typically as a thin film on the stop layer 220. The photoresist is subsequently exposed through a mask in a conventional lithographic process. The mask typically contains transparent and opaque features that define openings corresponding to features to be formed in the photoresist.

In a conventional exposure process, features are formed by plasma etch using the photoresist as a mask. The photoresist mask, however, is eroded during the plasma etch and the resulting pattern size becomes larger than the original dimension. Consequently, patterning small dimensions becomes more difficult to achieve. The stop layer 220, the hardmask, is more resistant to etching species than the photoresist material and acts as a guide for etching. With the use of the hardmask, the dimensions of the features being patterned with the mask may be controlled with greater accuracy. The use of the hardmask, stop layer 220, permits the use of existing conventional stepped lithographic equipment avoiding the cost of newer and more expensive stepper lithographic equipment that employ shorter wavelengths.

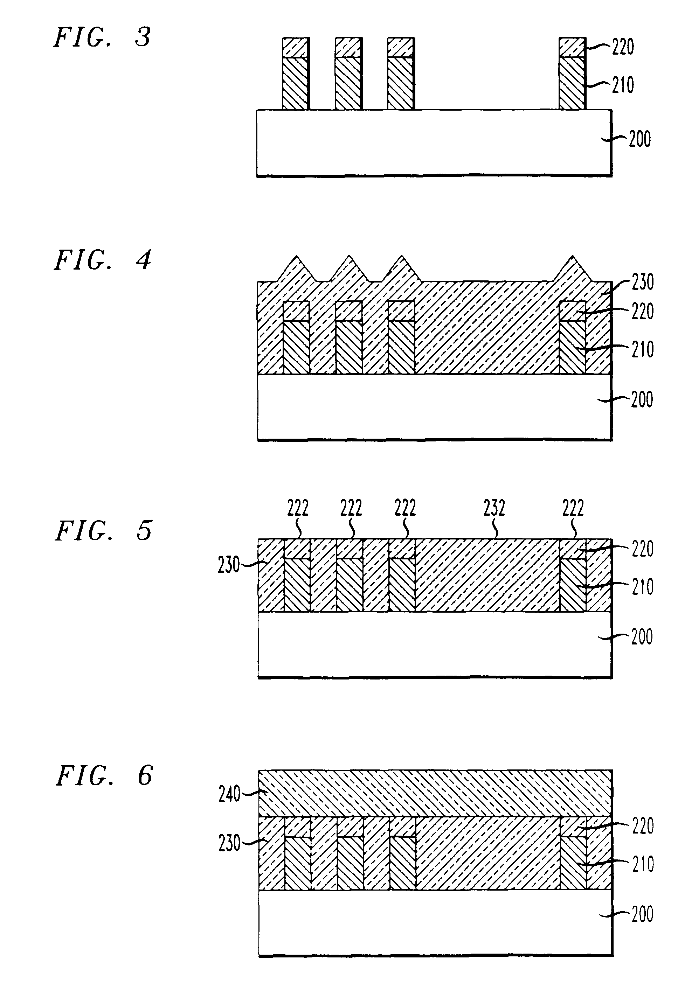

After the photoresist is exposed to radiation, such as ultraviolet light, and developed, an etched pattern is produced. The pattern in the photoresist is transferred to the stop layer 220, as is shown in Fig. 3, illustratively using reactive ion etching, a conventional process well known in the art. The remaining photoresist is then removed. The openings in the intermediate layer 210 are formed using conventional processes. Other methods besides photolithography may be used to form the pattern in the stop layer 220 and the intermediate layer 210 as is known in the art.

At step 115, a second layer 230 is formed on the patterned intermediate layer 210 and the stop layer 220. The second layer 230 may be a high density plasma oxide. Alternatively, the second layer 230 may be a low dielectric constant material. The thickness of the second layer 230 may be illustratively at least 1000Å higher than the step height of the intermediate layer 210 and the stop layer 220.

At step 120, the device is polished using chemical-mechanical polishing (CMP). The polisher used for CMP is, for example, an Auriga Planarization System, Auriga-C Planarization System, or a CMP 5, each available from Speedfam of 7406 West Detroit, Chandler, Arizona 85228. A slurry used for polishing the wafer comprises an abrasive component and a component having, for example, a high oxide/nitride selectivity. A slurry with a high oxide/nitride selectivity is selected when the stop layer 220 includes nitrides and the second layer 230 includes oxides. One such slurry is STI slurry XSHD3562 available from Rodel Inc. The slurry is a ceria based slurry, Corundum™, with an oxide/nitride selectivity that may be as high as 150. Others slurries may be used.

In the CMP process, the oxide is removed by a combination of physical, i.e., mechanical abrasion, and chemical, i.e., etching, processes. When the slurry and the CMP's pad (not shown) are pressed onto the second layer 230, typically at a pressure of approximately 6 to 8 psi, the high oxide/nitride selective component of the slurry reacts with the second layer 230. The layer is then readily removed with the abrasive component of the slurry. This process is repeated until the upper surface 222 of the stop layer 220 and the upper surface 232 of the second layer 230 form a surface that is substantially uniform and/or substantially flat. Alternatively, this process may be repeated until the stop layer 220 is reached. The high selectivity of the slurry allows for ovcr-polish without attacking the intermediate layer 210. The stop layer 220 serves as a stop layer for the CMP process. As a result, the need for accurate end point capability is not necessary.

At step 125, a third layer 240, shown in Fig. 6, is formed on the second layer 230 and the stop layer 220 to complete an inter-dielectric stack. The thickness of the third layer 240 is controlled and is uniform across the die and the wafer because of the prior planarization. The third layer 240 is, for example, a high density plasma oxide or PETEOS layer. Finally, vias (not shown) are formed. The stop layer 220 allows for a more robust planarization process.

Although the invention has been described with reference to exemplary embodiments, it is not limited to those embodiments. Rather, the appended claims should be construed to include other variants and embodiments of the invention which may be made by those skilled in the art without departing from the true spirit and scope of the present invention.

## Claims

1. A process for manufacturing an integrated circuit comprising the steps of:
(a) forming (e.g., 105) a stop layer (e.g., 220) on a substrate;
(b) patterning (e.g., 110) the stop layer (e.g., 220) to form a patterned layer;
(c) forming (e.g., 115) a first layer (e.g., 230) on the patterned layer;
(d) polishing (e.g., 120) the first layer (e.g., 230);
(e) forming (e.g., 125) a second layer (e.g., 240) on the polished first layer.

2. The process according to claim 1 wherein an intermediate layer (e.g., 210) is formed between the stop layer and the substrate, and is for example a metal layer.

3. The process according to claim 2 further comprising the step of patterning (e.g., 110) the intermediate layer.

4. The process according to claim 1, wherein the patterned layer has a first upper surface and the first layer has a second upper surface and the process further comprises the step of polishing (e.g., 120) the second layer (e.g., 230) so that the first upper surface and the second upper surface form a substantially flat surface.

5. The process according to claim 2, wherein the stop layer is more resistant to polishing than the first layer, or is a dielectric anti-reflective coating, or is one of SiON and Si₃N₄, or is more resistant to polishing than the metal layer.

6. The process according to claim 1 wherein the second layer has a low dielectric constant.

7. The process according to claim 1 further comprising the step of polishing (e.g., 120) the patterned layer.

8. A process for manufacturing an integrated circuit including a metal layer formed on a substrate, the process comprising the steps of:
(a) forming a stop layer (e.g., 220) on the metal layer (e.g., 210);
(b) patterning the stop layer (e.g., 220) and the metal layer (e.g., 210) to form a patterned layer;
(c) forming a first layer (e.g., 230) on the patterned layer (e.g., 220,210);
(d) polishing the first layer (e.g., 230) and the stop layer (e.g., 220); and
(e) forming a second layer (e.g., 240) on the polished first layer (e.g., 230) and the polished stop layer (e.g., 220).

9. The process according to claim 8 wherein the patterned layer (e.g., 210,220) has an first upper surface and the first layer has a second upper surface and the process further comprises the step of polishing the patterned layer (e.g., 210,220) and the first layer (e.g., 230) so that the first upper surface and the second upper surface form a substantially flat surface.

10. The process according to claim 8, wherein the stop layer (e.g., 220) is more resistant to polishing that the metal layer (e.g., 210).

11. An integrated circuit comprising:
a patterned metal (e.g., 210) having openings;
a stop layer (e.g., 220) formed on the patterned metal layer (e.g., 210); and
an oxide (e.g., 240) formed in the openings and on the stop layer where the stop layer is more resistant to polishing than the oxide.

12. The integrated circuit according to claim 11 wherein the stop layer is a dielectric anti-reflective layer that includes nitrogen, such as from Si₃N₄ and/or SiON.

13. An integrated circuit comprising:
a patterned metal (e.g., 210) having openings;
a stop layer (e.g., 220) formed on the patterned metal layer, the stop layer has a first top surface; and
an oxide (e.g.,230) formed in the openings. the oxide having a second top surface where the first top surface and the second top surface form a substantially flat surface;
wherein the stop layer is more resistant to polishing than the oxide.

14. A process for manufacturing an integrated circuit comprising the steps of:
(a) forming a stop layer (e.g., 220) on a substrate;
(b) patterning the stop layer (e.g., 220) to form a patterned layer;
(c) forming a first layer (e.g., 230) on the patterned layer;
(d) polishing the first layer (e.g., 230) and the patterned layer (e.g., 220);
(e) forming a second layer (e.g., 240) on the polished first layer (e.g., 230) and the polished patterned layer (e.g., 220)
